# EUROPÄISCHE PATENTSCHRIFT

(11) **EP 2 732 069 B1**
(45) Veröffentlichungstag und Bekanntmachung des Hinweises auf die Patenterteilung: **04.11.2020**
(21) Anmeldenummer: 12734895.1
(22) Anmeldetag: 05.07.2012
(51) Int. Cl.: C23C 16/455, C30B 25/14, C23C 16/30

(54) **GASEINLASSORGAN EINES CVD-REAKTORS**
GAS INLET MEMBER OF A CVD REACTOR
ORGANE D'ADMISSION DE GAZ D'UN RÉACTEUR À VARIATION CONTINUE

(30) Priorität: 12.07.2011 DE 102011051778; 19.12.2011 DE 102011056589
(43) Veröffentlichungstag der Anmeldung: 21.05.2014
(73) Patentinhaber: Aixtron SE, 52134 Herzogenrath (DE)
(72) Erfinder: SILVA, Hugo, 52074 Aachen (DE); JOUAULT, Nico, F-31300 Toulouse (FR); SAYWELL, Victor, Great Barton Suffolk IP31 2SW (GB); CRAWLEY, Fred, Orwell Royston Hertfordshire SG8 5QN (GB); DAUELSBERG, Martin, 52074 Aachen (DE); LINDNER, Johannes, 52159 Roetgen (DE)
(74) Vertreter: Grundmann, Dirk
(86) Internationale Anmeldenummer: PCT/EP2012/063072
(87) Internationale Veröffentlichungsnummer: WO 2013/007580

(56) Entgegenhaltungen:
- WO-A2-2011/044451
- US-A1- 2006 263 522

## Beschreibung

Die Erfindung betrifft ein Gaseinlassorgan eines CVD-Reaktors mit einem Gaseinlassgehäuse, welches zumindest ein erstes, von einer ersten Zuleitung mit einem ersten Prozessgas speisbares Gasverteilvolumen aufweist, welches eine Vielzahl von jeweils als Rohr ausgebildete Gasleitungen aufweist, die in erste Öffnungen einer vor einer Einlassgehäusewand angeordneten Gasauslassplatte eingreifen und durch die das erste Prozessgas in eine unter der Gasauslassplatte angeordneten Prozesskammer eintritt, mit einem zwischen der Gaseinlassgehäusewand und der Gasauslassplatte angeordneten Abstandsfreiraum.

Die WO 2011/044451 A2 beschreibt ein Gaseinlassorgan mit zwei vertikal übereinander angeordneten Gasverteilvolumina, wobei zwischen den beiden Gasverteilvolumina eine Kühlmittelkammer angeordnet ist. Die Gaseinlassgehäusewand bildet Öffnungen aus, durch die ein Prozessgas in eine Prozesskammer treten kann. Die Gaseinlassgehäusewand wird von der untersten Wandung des unteren Gasverteilvolumens ausgebildet.

Aus der US 2009/0169744 A1 bzw. der US 2006/0263522 A1 ist jeweils ein Gaseinlassorgan bekannt, bei dem ein Gasverteilvolumen über Röhrchen mit der Decke einer Prozesskammer verbunden ist. Durch die Röhrchen kann das in das Gasverteilvolumen eingespeiste Prozessgas in die unterhalb der Gasauslassplatte angeordnete Prozesskammer eintreten. Die Prozesskammerdecke bildet hier eine Gasauslassplatte aus, die eine Gehäusewand eines Gasverteilvolumens ausbildet.

Die DE 103 20 597 A1 beschreibt ein Verfahren und eine Vorrichtung zum Abscheiden von Halbleiterschichten mit zwei Prozessgasen, wobei die Prozessgase durch ein Gaseinlassorgan in die Prozesskammer eingeleitet werden.

Die DE 697 06 248 T2 beschreibt ein als shower head ausgebildetes Gaseinlassorgan, bei dem die Gasleitungen auf den Eckpunkten von Dreiecken liegen. Innerhalb des Gaseinlassorgans befinden sich Kühlkammern, um die Gaseinlassgehäusewand zu kühlen.

Ein aus mehreren übereinander angeordneten Kammern bestehendes Gaseinlassorgan mit einer Vielzahl von Gasaustrittsöffnungen, die auf den Eckpunkten gleichseitiger Dreiecke liegen, beschreibt die US 6,544,341 B1.

Die US 7,976,631 B2 beschreibt ein Gaseinlassorgan mit aus der Gaseinlassgehäusewand in Richtung auf die Prozesskammer ragenden gekühlten Strukturen.

Die US 2006/0021574 A1 beschreibt ein Gaseinlassorgan, wobei das Prozessgas durch eine poröse Gasaustrittsplatte strömt.

Die Figuren 3 und 4 der DE 10 2006 018 515 A1 beschreiben ein Gaseinlassorgan, welches Teil eines CVD-Reaktors ist. Es hat die Form eines Showerheads und ist oberhalb einer Prozesskammer angeordnet, deren Boden von einem Suszeptor ausgebildet ist, auf den zu beschichtende Substrate, insbesondere Halbleitersubstrate aufgelegt werden können. Unmittelbar unterhalb des Gaseinlassorgans befindet sich eine Gasauslassplatte, die während des Abscheideprozesses in einer berührenden Anlage an einer Gaseinlassgehäusewand liegt. Um diese Gasauslassplatte zu reinigen, kann sie in Richtung auf den Suszeptor verlagert werden. Da die Gaseinlassgehäusewand des Gaseinlassorgans gekühlt wird und nur der Suszeptor beheizt wird, kann zufolge dieser Maßnahme die Gasauslassplatte auf eine höhere Temperatur gebracht werden, so dass sie durch Einleiten eines Ätzgases, beispielsweise HCl von parasitären Ablagerungen gereinigt werden kann.

Bei CVD-Reaktoren mit Gaseinlassorganen, bei denen die Prozesskammerdecke von der Gaseinlassgehäusewand selbst gebildet ist, kommt es an der gekühlten Gaseinlassgehäusewand zu parasitärem Wachstum. Dies kann zu einer unerwünschten Partikelbildung innerhalb der Prozesskammer führen. Außerdem können die Mündungen der Gaszuleitungen verstopfen. Dies hat zur Folge, dass die Gaseinlassorgane häufig mechanisch gereinigt werden müssen. Zur Reinigung der Gasaustrittsseite des Gaseinlassorganes muss das gesamte Reaktorgehäuse geöffnet werden.

Der Erfindung liegt daher die Aufgabe zu Grunde, Maßnahmen anzugeben, mit denen die Reinigungszyklen verlängert werden können.

Die aus dem oben genannten Stand der Technik her bekannte Gasauslassplatte besitzt Öffnungen zum Durchtritt des Prozessgases. Die Gasauslassplatte liegt zwar in berührender Anlage an der gekühlten Gaseinlassgehäusewand. Gleichwohl wird die Gasauslassplatte aber durch Wärmeleitung über das Prozessgas durch die Prozesskammer oder über Wärmestrahlung vom Suszeptor her beheizt. Die Mündungen der Öffnungen der Gasauslassplatte können so eine Temperatur erreichen, bei der sich das durch die Öffnungen hindurchtretende Prozessgas zerlegt. Die Zerlegungsprodukte können im Bereich der Mündung miteinander reagieren. Dies kann auch zu parasitären Reaktionen in der Gasphase führen, wo sich unerwünschte Addukte bilden können.

Der Erfindung liegt daher die weitere Aufgabe zu Grunde, Maßnahmen anzugeben, mit denen unerwünschte Vorreaktionen vermindert werden.

Bei einem CVD-Reaktor, bei dem die Prozesskammerdecke unmittelbar gekühlt wird, muss wegen der hohen Wärmeabfuhr eine hohe Wärmeleistung aufgebracht werden, um den Suszeptor auf die gewünschten Prozesstemperaturen aufzuheizen.

Der Erfindung liegt damit die weitere Aufgabe zu Grunde, die Energieeffizienz zu erhöhen.

Bei einem Abscheideprozess, bei dem Hydride, beispielsweise Arsin oder Phosphin verwendet werden, die mit metallorganischen Verbindungen der III. Hauptgruppe in der Prozesskammer zusammen reagieren, haben Feuchtigkeitsrückstände negative Auswirkungen auf das Schichtwachstum.

Der Erfindung liegt daher die weitere Aufgabe zu Grunde, Maßnahmen anzugeben, mit denen sich die feuchtigkeitsverursachten Effekte vermindern lassen.

Zumindest eine dieser Aufgaben wird durch die in den Ansprüchen angegebene Erfindung gelöst.

Zunächst und im Wesentlichen wird vorgeschlagen, dass die Gasauslassplatte gegenüber der Gaseinlassgehäusewand thermisch entkoppelt ist. Die Mündungen der Gasleitungen sind hingegen mit dem gekühlten Bereich des Gaseinlassgehäuses gekoppelt. Wird die Unterseite des Gaseinlassorgans durch Strahlungswärme vom beheizten Suszeptor der Prozesskammer her beheizt, so kann sich die Prozesskammerdecke im Bereich der Gasauslassplatte stärker aufheizen als im Bereich der Mündungen der Gasleitungen. Hierzu ist die Wärmeleitfähigkeit des Materials aus dem die Gasauslassplatte gefertigt ist geringer als die des Materials aus dem die Gasleitungen gefertigt sind. Die Gasleitungen, durch die ein erstes Prozessgas in die Prozesskammer eingebracht wird, setzen sich über die Gaseinlassgehäusewand fort. Die Gasleitungen sind Röhrchen, die das erste Gasverteilvolumen durch die von einem Kühlmittel gespülte Kühlkammer hindurch mit der Decke der Prozesskammer verbinden. Diese Gasleitungen haben erfindungsgemäß Fortsätze bzw. sie sind derart verlängert, dass sie bis in die Öffnungen der von der Gaseinlassgehäusewand beabstandeten Gasauslassplatte hineinreichen. Die Gasleitungen können dabei soweit in die Gasauslassplatte hineinreichen, dass ihre Mündungen in der zur Prozesskammer weisenden Oberfläche der Gasauslassplatte liegen. Dabei müssen die Mündungsflächen nicht exakt flächenbündig in der Oberfläche der Gasauslassplatte liegen. Kleinere Stufen insbesondere von der Größenordnung einer Spaltweite um die Gasleitungen sind möglich, gegebenenfalls sogar erwünscht. Ferner ist vorgesehen, dass die Gasauslassplatte gegenüber der gekühlten Gaseinlassgehäusewand thermisch entkoppelt ist. Hierzu ist die Gasauslassplatte bevorzugt durch einen Abstandsfreiraum in Form eines Spaltes von der Gaseinlassgehäusewand beabstandet. Dieser Spalt erstreckt sich bevorzugt über die gesamte Fläche der Gasauslassplatte, so dass die Gasauslassplatte lediglich an ihrem Rand mit dem Gaseinlassorgan verbunden ist.

Es ist vorgesehen, dass mit dem duschkopfartig ausgebildeten Gaseinlassorgan zumindest ein weiteres Prozessgas in die Prozesskammer eingeleitet werden kann. Hierzu bildet das Gaseinlassorgan ein zweites Gasverteilvolumen aus, das ebenfalls mittels Röhrchen, die Gaszuleitungen bilden, mit der Gaseinlassgehäusewand verbunden sind. Die beiden Gasverteilvolumina können übereinander geschichtet angeordnet sein. Die zweiten Gaszuleitungen, durch die das zweite Prozessgas, bei dem es sich bevorzugt um ein Hydrid der V. Hauptgruppe handelt, münden in den Spalt zwischen der Gaseinlassgehäusewand und der Gasauslassplatte. Die Mündung der zweiten Gasleitungen liegen bündig in der Gaseinlassgehäusewand. Die Gasleitungsfortsätze der ersten Gasleitungen, durch die bevorzugt eine metallorganische Verbindung eines Elementes der III. Hauptgruppe in die Prozesskammer eingeleitet wird, liegen bevorzugt bündig in der zur Prozesskammer weisenden Unterseite der Gasauslassplatte. Die Öffnung, durch die die Gasleitungsfortsätze der ersten Gasleitungen ragen, haben vorzugsweise eine größere Öffnungsweite als der Außendurchmesser der Gasleitungsfortsätze, so dass sich um die Gasleitungsfortsätze ein Ringspalt ausbildet, durch den Gas, welches in den Spalt zwischen Gaseinlassgehäusewand und Gasauslassplatte eingebracht wird, hindurchtreten kann.

Weiterhin ist vorgesehen, dass die Gasauslassplatte weitere Öffnungen aufweist, durch die das in den Spalt gebrachte Gas treten kann. Bei diesem Gas handelt es sich bevorzugt um das zweite Prozessgas, das so in die Prozesskammer eintreten kann. Die dem zweiten Prozessgas zugeordneten Öffnungen der Gasauslassplatte können mit den Mündungen der zweiten Gasleitungen fluchten. Die Röhrchen, die die ersten Gasleitungen ausbilden, sind bevorzugt aus Metall. Die Gasleitungsfortsätze sind materialeinheitlich mit den Röhrchen verbunden. Es handelt sich dabei somit um aus der Gaseinlassgehäusewand vorspringende Abschnitte der die ersten Gasleitungen ausbildenden Metallröhrchen. Zufolge dieser Ausgestaltung sind die Mündungen der ersten Gasleitungen thermisch an den gekühlten Abschnitt des Gaseinlassorgans gekoppelt. Die Mündungen der ersten Gasleitungen werden somit auf Temperaturen gehalten, die unterhalb der Zerlegungstemperatur des ersten Prozessgases sind, das durch die ersten Gasleitungen in die Prozesskammer einströmt. Gegenüber diesen "kalten" Abschnitten der Prozesskammerdecke kann sich die Gasauslassplatte aufheizen. Sie ist thermisch gegenüber dem gekühlten Abschnitt des Gaseinlassorgans entkoppelt und wird durch Wärmeleitung oder durch Wärmestrahlung vom Suszeptor aufgeheizt. Während das erste Prozessgas durch "kalte" Austrittsöffnungen in die Prozesskammer tritt, tritt das zweite Prozessgas durch "heiße" Öffnungen in die Prozesskammer.

In einer Weiterbildung der Erfindung, die eine eigenständige Bedeutung besitzt, ist vorgesehen, dass die ersten Zuleitungen in der Gasauslassplatte auf den Eckpunkten gleichseitiger Dreiecke liegen. Hierdurch ergibt sich insgesamt eine hexagonale Anordnung der ersten Zuleitung in der Gasaustrittsebene der Gasauslassplatte. Die zweiten Austrittsöffnungen in der Gasauslassplatte, durch die das zweite Prozessgas in die Prozesskammer eintritt, liegen bevorzugt auf den Mittelpunkten dieser Dreiecke. Demzufolge liegen auch die Mündungen der zweiten Gasleitungen auf den Eckpunkten gleichseitiger Dreiecke. Das zweite Prozessgas kann nicht nur durch diese, ihm zugeordnete Öffnungen der Gasauslassplatte in die Prozesskammer treten. Das zweite Prozessgas kann auch durch den Ringspalt um die Gasleitungsfortsätze in die Prozesskammer eintreten. Durch diese Ringspalte kann aber auch ein Spülgas in die Prozesskammer eingeleitet werden, so dass ein Kontakt zwischen den beiden Prozessgasen in einen Bereich heißerer Gastemperaturen verschoben wird. Zur Einleitung eines Spülgases können die ersten Gasleitungen aber auch konstruktiv weitergebildet sein. Beispielsweise können die ersten Gasleitungen innerhalb eines Rohres mit einem größeren Durchmesser verlaufen, so dass sich um die ersten Gasleitungen ein Ringspalt bildet, durch das ein Spülgas in die Prozesskammer eingleitet wird. Die beiden ineinandergeschachtelten Rohre münden durch die Öffnungen in der Gasauslassplatte in die Prozesskammer. Auch hier kann ein derart ineinandergeschachteltes Röhrchen von einem Ringspalt umgeben sein, durch welches das zweite Prozessgas in die Prozesskammer eingeleitet wird. Es ist aber auch möglich, dass durch den sich um die erste Gasleitung ausbildenden Ringspalt ein weiteres Prozessgas in die Prozesskammer eingeleitet wird.

In einer Weiterbildung der Erfindung ist vorgesehen, dass die Gasauslassplatte höhenvariierbar gegenüber der Gaseinlassgehäusewand bzw. dem Suszeptor im Reaktorgehäuse angeordnet ist. Sollen in der Prozesskammer ein oder mehrere auf dem Suszeptor aufliegende Substrate mit einer Schicht beschichtet werden, so befindet sich die Gasauslassplatte in einer Betriebsstellung, in der sie durch einen geringen Abstandsfreiraum von der Gaseinlassgehäusewand getrennt ist. Sie befindet sich in einer thermisch entkoppelten Position gegenüber der Gaseinlassgehäusewand. Die ersten Gasleitungen ragen mit ihren Fortsätzen in die Öffnungen der Gasauslassplatte hinein, wobei die Fortsätze seitlich von der Wandung der Öffnung beabstandet sind. Durch die Fortsätze tritt ein erstes Prozessgas in die Prozesskammer hinein. Durch den Ringspalt zwischen den Fortsätzen und der Öffnungswandung kann das zweite Prozessgas oder ein Spülgas in die Prozesskammer eintreten. Zur Reinigung der Prozesskammer und insbesondere der zur Prozesskammer weisenden Oberfläche der Gasauslassplatte kann in die Prozesskammer ein Ätzgas eingeleitet werden. Es ist aber auch möglich, zusätzlich oder alternativ dazu die Gasauslassplatte in Richtung auf den beheizten Suszeptor zu verlagern und/oder den Abstand zur gekühlten Gaseinlassgehäusewand zu vergrößern. Indem dadurch die Gasauslassplatte näher an die heißere Oberfläche des Suszeptors gebracht wird, lässt sie sich auf eine höhere Temperatur aufheizen, bei der die an der Unterseite der Gasauslassplatte anhaftenden parasitären Beläge entfernt werden können. Zur Vertikalverlagerung kann die Vorrichtung einen Hubmechanismus aufweisen, mit dem der Abstand zwischen Gaseinlassgehäusewand und Gasauslassplatte variierbar ist. In einer Weiterbildung der Erfindung ist die Gasauslassplatte derart an der Unterseite des Gaseinlassorgans befestigt, dass sie in ihrer Erstreckungsrichtung verlagerbar ist. Durch eine derartige Horizontalverlagerbarkeit der Gasauslassplatte lässt sich erreichen, dass die Gaseinleitungsfortsätze von einer Betriebsstellung, in der sie frei in die Öffnungen hineinreichen, in eine andere Betriebsstellung gebracht wird, in der jeweils die Wandung eines gekühlten Gaseinleitungsfortsatzes an der Wandung der Öffnung anliegt. Die Gasauslassplatte ist dadurch in eine Wärmeleitverbindung mit den Gasleitungsfortsätzen bringbar. Mit diesen Maßnahmen ist es möglich, die Gasauslassplatte beim Wachstumsprozess auf Temperaturen unter 450° C, bevorzugt unter 400° C zu halten. Durch eine Modifikation der Lage der Gasauslassplatte gegenüber der Gaseinlassgehäusewand ist es möglich, in einer anschließenden Reinigungsphase die Oberflächentemperatur der zur Prozesskammer weisenden Seite der Gasauslassplatte auf Temperaturen größer 500° C zu bringen. Als besonders bevorzugt wird dabei die Kombination angesehen, in der die Gasauslassplatte nicht nur vertikal, sondern auch horizontal verlagerbar ist. In einer Weiterbildung der Erfindung sind die Öffnungen in der Gasauslassplatte dahingehend modifiziert, dass sie eine in den Abstandsfreiraum ragende Hülse aufweisen. Die Hülse bildet einen Rohrabschnitt, in den teleskopartig die erste Gasleitung hineinragt. Zufolge dieser Ausgestaltung lässt sich die Vertikalposition der Gasauslassplatte über einen relativ großen Bereich variieren, ohne dass die Mündung der Gasleitungsfortsätze aus der ihnen zugeordneten Hülse heraustritt und frei in den Abstandsfreiraum hineinragt. Aus der Mündung der ersten Gasleitung heraustretende Prozessgase geraten somit auch bei einer Vergrößerung des Abstandes zwischen Gaseinlassgehäusewand und Gasauslassplatte nicht in den Abstandsfreiraum. Eine Mischung der Prozessgase findet somit erst innerhalb der durch die Hülse verlängerten Öffnung statt. Das zweite Prozessgas tritt durch den Ringspalt zwischen Hülseninnenwand und Außenwandung des Gasleitungsfortsatzes in die Öffnung hinein. In einer Weiterbildung der Erfindung ist vorgesehen, dass die Wandungen der Öffnung profiliert sind. Beispielsweise können die Öffnungen der Gasauslassplatte Fasen oder Senkungen aufweisen. Diese Profilierungen können sich auf der von der Prozesskammer wegweisenden Seite der Gasauslassplatte befinden. Derartige Fasen vereinfachen darüber hinaus auch die Montage, da sie einen Selbstzentriereffekt bewirken. Liegen Toleranzfehler vor, minimieren die Fasen eventuelle thermische Brücken zwischen den Gasleitungsfortsätzen und dem Öffnungsrand. In diesem Fall kann es vorteilhaft sein, wenn die Profilierungen, also die Fasen bzw. Senkungen auf der zur Prozesskammer weisenden Seite der Gasauslassplatte angeordnet sind. Hierdurch vermindert sich auch die Wachstumsrate an der Kante, so dass die Betriebszeit zwischen zwei Reinigungsschritten verlängert wird. Schließlich ist es von Vorteil, wenn der Querschnitt der Öffnung einen unrunden Verlauf hat, insbesondere in die Öffnung hineinragende Vorsprünge aufweist, die bei einer Horizontalverlagerung der Gasauslassplatte in einen thermischen Kontakt mit den Gasleitfortsätzen treten können.

Ausführungsbeispiele der Erfindung werden nachfolgend anhand beigefügter Zeichnungen erläutert. Es zeigen:
- Fig.1: schematisch den Aufbau eines Reaktorgehäuses eines CVD-Reaktors,
- Fig.2: den Ausschnitt II - II in Figur 1,
- Fig.3: den Ausschnitt III - III in Figur 1,
- Fig.4: den Ausschnitt IV - IV in Figur 3,
- Fig.5: schematisch die Anordnung der Gasaustrittsöffnungen in der Gasauslassplatte 14,
- Fig.6: ein zweites Ausführungsbeispiel der Erfindung in einer Darstellung gemäß Figur 4,
- Fig.7: ein drittes Ausführungsbeispiel der Erfindung in einer Darstellung gemäß Figur 4,
- Fig.8: ein viertes Ausführungsbeispiel der Erfindung in einer Darstellung gemäß Figur 1, wobei die Gasauslassplatte 14 in Vertikalrichtung verlagerbar ist, in einer Wachstumsbetriebsstellung,
- Fig.9: den vergrößerten Ausschnitt IX - IX in Figur 8,
- Fig.10: eine Darstellung gemäß Figur 9, jedoch mit in vertikaler Richtung abgesenkter Gasauslassplatte 14,
- Fig.11: ein fünftes Ausführungsbeispiel der Erfindung, bei dem die Öffnung 16 von einer in den Abstandsfreiraum 20 hineinragenden Hülse 30 gebildet ist, in einer Wachstumsprozessstellung,
- Fig.12: eine Darstellung gemäß Figur 11, jedoch mit abgesenkter Gasauslassplatte 14,
- Fig.13: als sechstes Ausführungsbeispiel eine Darstellung gemäß Figur 2 mit einer profilierten Wandung der Öffnung 16, die als zum Abstandsfreiraum 20 weisende Abschrägung ausgebildet ist,
- Fig.14: als siebtes Ausführungsbeispiel eine Darstellung gemäß Figur 13, wobei die Profilierung der Wandung der Öffnung 16 als umlaufende Ringkehle ausgebildet ist, deren Öffnung zum Abstandsfreiraum 20 weist,
- Fig.15: als achtes Ausführungsbeispiel eine weitere Variante einer Profilierung der Öffnungswandung 16, wobei hier eine Abschrägung 28 zur Prozesskammer weist,
- Fig.16: ein neuntes Ausführungsbeispiel der Erfindung in einer Darstellung gemäß Figur 1, wobei die Gasauslassplatte 14 nicht nur in Vertikalrichtung, sondern auch in Horizontalrichtung verlagerbar ist,
- Fig.17: eine vergrößerte Darstellung des bei abgesenkter Gasauslassplatte 14 in die Öffnung 16 hineinragenden Gasleitungsfortsatzes 15, dessen Wandung zufolge einer Horizontalverlagerung der Gasauslassplatte 14 in wärmeleitenden Kontakt an die Öffnungswandung gebracht worden ist und
- Fig.18: den Schnitt gemäß der Linie XVIII - XVIII, wobei hier die Umfangskonturlinie der Öffnung 16 unrund gestaltet ist in dem vier radial in die Öffnung hineinragende Vorsprünge 23 vorgesehen sind, wobei ein Vorsprung 32 in berührender Anlage am Gasleitungsfortsatz 15 anliegt.

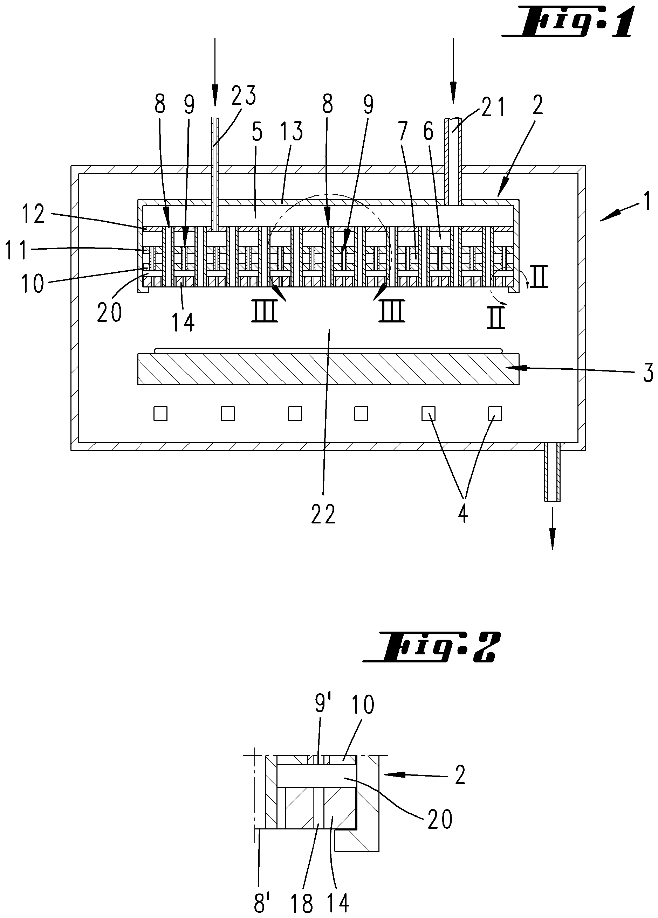

Der erfindungsgemäße CVD-Reaktor besitzt ein nicht dargestelltes Gasbevorratungs- und Dosiersystem, in dem die Prozessgase mit Trägergasen gemischt werden und durch Leitungen den CVD-Reaktor zugeführt werden. In der Figur 1, die den Querschnitt eines Reaktorgehäuses 1 darstellt, sind lediglich zwei Gaszuleitungen 21, 23 für ein erstes und ein zweites Prozessgas dargestellt. Die Zuleitungen 21, 23 münden jeweils in ein Gasverteilvolumen 5 beziehungsweise 6. Die Gasverteilvolumina 5, 6 liegen übereinander und sind von einer Trennplatte 12 voneinander getrennt. Jedes Gasverteilvolumen 5, 6 ist mit separaten Röhrchen, die Gasleitungen 8, 9 ausbilden, mit einer Gaseinlassgehäusewand 10 verbunden. Das aus den Mündungen der Gasleitungen 8, 9 austretende Prozessgas gelangt in eine unterhalb des Gaseinlassorgans 2 angeordnete Prozesskammer 22, deren Boden von einem Suszeptor 3 gebildet wird. Auf dem Suszeptor 3 befinden sich ein oder mehrere zu beschichtende Substrate. Der Suszeptor 3 wird von unten her mit einer Heizung 4 auf eine Prozesstemperatur aufgeheizt. Diese kann im Bereich zwischen 500° und 1.000° Celsius liegen. Das Reaktorgehäuse 1 ist mit einer nicht dargestellten Vakuumpumpe verbunden, so dass innerhalb der Prozesskammer Totaldrücke von typischerweise 50 bis 800 mbar eingestellt werden können. Der Durchmesser des Suszeptors 3 entspricht etwa 300 mm bis 600 mm. Der Durchmesser des duschkopfartig ausgebildeten Gaseinlassorgans 2 entspricht in etwa dem Durchmesser des Suszeptors 3.

Unmittelbar oberhalb der Gaseinlassgehäusewand 10 befindet sich eine Kühlmittelkammer 7, die von einem Kühlmittel durchströmt wird, so dass die Gaseinlassgehäusewand 10 auf eine Temperatur zwischen 60° und 200° Celsius temperiert wird.

Unterhalb der Gaseinlassgehäusewand 10 befindet sich ein gasgespülter Spalt 20. In den Spalt 20 münden die dem zweiten Prozessgas zugeordneten zweiten Gasleitungen 9. Diese werden von Röhrchen ausgebildet, die durch die Kühlmittelkammer 7 hindurchtreten.

Die ebenfalls von Röhrchen ausgebildeten ersten Gasleitungen 8, durch die das erste Prozessgas strömt, kreuzen nicht nur die Kühlmittelkammer 7 sondern auch das zweite Gasverteilvolumen 6. Die die ersten Gasleitungen 8 ausbildenden Röhrchen setzen sich über die Gaseinlassgehäusewand 10 fort und bilden Gasleitungsfortsätze 15 aus, die zunächst den Spalt 20 kreuzen und dann in eine Öffnung 16 einer Gasauslassplatte 14 eintreten.

Die Gasauslassplatte 14 wird lediglich an ihrem im Ausführungsbeispiel kreisrunden Rand gehalten. Wie aus der Figur 2 ersichtlich, wird sie von einer den Rand des Gaseinlassorgans 2 bildenden Wandung randseitig gehalten, im Ausführungsbeispiel unterfangen.

Die Gasauslassplatte 14 kann aus einem wärmeleitenden oder einem nichtwärmeleitenden Werkstoff bestehen. Die Gasauslassplatte 14 kann aus Quarz, aus Graphit oder einem Metall bestehen.

Die Öffnungen 16, in die die Gasleitungsfortsätze 15 eintreten, haben einen größeren Durchmesser als die Gasleitungen 8, so dass sich um die Mündungsabschnitte der Gasleitungen 8 jeweils ein Ringspalt 17 ausbildet. Die Mündungen 8' der Gasleitungen 8 liegen bündig in der zur Prozesskammer 22 hinweisenden Oberfläche der Gasauslassplatte 14.

Die Gasauslassplatte 14 besitzt weitere Öffnungen 18, die einen kleineren Durchmesser aufweisen als die Öffnungen 16. Die Öffnungen 18 liegen in Fluchtlage zu den Mündungen 9' der zweiten Gasleitungen 9.

Die Zwischenwand 11, die die Kühlkammer 7 zum zweiten Gasverteilungsvolumen 6 begrenzt, die Zwischenwand 12, die die beiden Gasverteilvolumina 5, 6 gegeneinander trennt, die Gaseinlassgehäusewand 13, durch die die Zuleitung 21, 23 hindurchgehen und die Gaseinlassgehäusewand 10 verlaufen parallel zueinander. Die Gaseinlassgehäusewand 10 verläuft in horizontaler Richtung. Die Gasauslassplatte 14 verläuft ebenfalls in horizontaler Richtung. Insofern verläuft die Gasauslassplatte 14 im Wesentlichen parallel zur Gaseinlassgehäusewand 10. Beide Platten (sowohl Gasauslassplatte 14 als auch Gaseinlassgehäusewand 10) müssen keine glatten Oberflächen aufweisen. Wenngleich das in den Zeichnungen dargestellte, bevorzugte Ausführungsbeispiel ebene Oberflächen zeigt, können die Oberflächen der Gaseinlassgehäusewand 10 und die Oberflächen der Gasauslassplatte 14 auch strukturiert beziehungsweise profiliert sein.

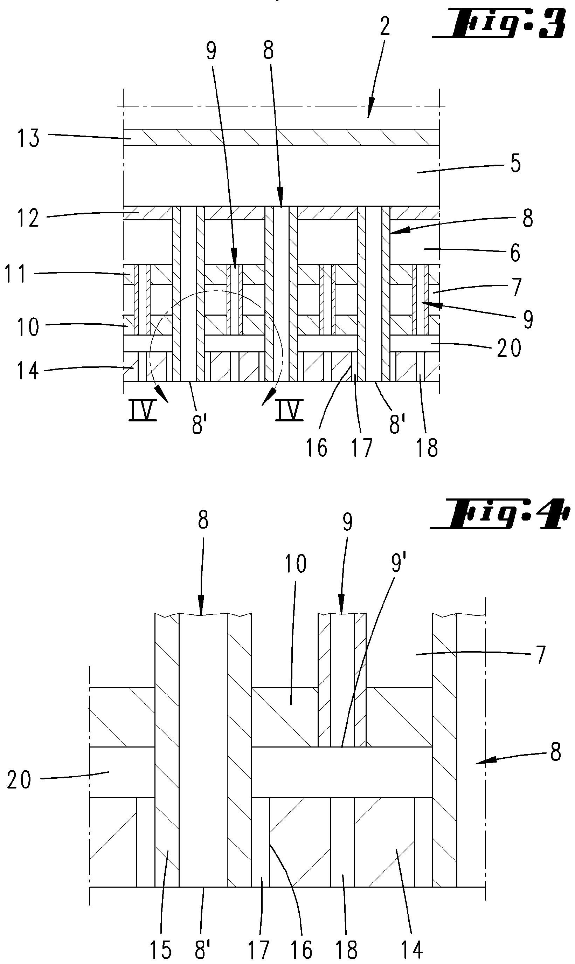

Bei dem in den Figuren 1 bis 4 dargestellten Ausführungsbeispiel wird die Gaseinlassgehäusewand 10 aktiv gekühlt. Der Suszeptor 3 wird aktiv geheizt. Durch die Zuleitung 23 wird ein erstes Prozessgas in Form einer metallorganischen Verbindung eines Elementes der III. Hauptgruppe eingebracht. Dies erfolgt zusammen mit einem Trägergas. Durch die Zuleitung 21 wird ein Hydrid eines Elementes der V. Hauptgruppe ebenfalls zusammen mit einem Trägergas eingeleitet. Diese Gase treten aus den Mündungen 8' beziehungsweise 9' in die Prozesskammer 22 ein und erwärmen sich dort. Es finden Gasphasenreaktionen statt, bei denen die Prozessgase vorzerlegt werden beziehungsweise bei denen sich Zwischenprodukte bilden. Auf der Oberfläche des Substrates werden durch pyrolytische Zerlegung der Prozessgase III - V Schichten abgeschieden.

Die metallorganischen Komponenten treten durch die ersten Gasleitungen 8 in die Prozesskammer 22 ein. Da diese thermisch an die Kühlmittelkammer 7 angekoppelt sind, haben die Mündungen 8' der ersten Gasleitungen eine Temperatur, die geringer ist als die Zerlegungstemperatur des ersten Prozessgases. Da die Gasauslassplatte 14 gegenüber der Kühlmittelkammer 7 beziehungsweise der Gaseinlassgehäusewand 10 thermisch entkoppelt ist, hat ihre zur Prozesskammer 22 weisenden Oberfläche eine wesentlich höhere Temperatur. Diese kann bei einem Wachstumsprozess im Bereich zwischen 250° und 600° Celsius liegen. Hierdurch wird der Wärmeübertrag zwischen Suszeptor 3 und Kühlkammer 7 reduziert, was die Energieeffizienz des CVD-Reaktors erhöht. Gleichzeitig findet eine gewisse thermische Aktivierung des zweiten, gegenüber dem ersten Prozessgas reaktionsträgerem Prozessgas statt.

Mit der erfindungsgemäßen Ausgestaltung des Gaseinlassorgans 2 lässt sich die Prozesskammerdecke in situ ätzen. Außerdem wird wegen der heißen Prozesskammerdecke das dortige Abscheiden parasitärer Reaktionsprodukte vermindert beziehungsweise ändert sich die Art der Belegung. Die in der erfindungsgemäßen Prozesskammer abgeschiedene parasitäre Belegung hat eine höhere Stabilität. Beim Ätzen wird die Prozesskammerdecke, also die Unterseite der Gasauslassplatte 14 auf Temperaturen größer 500° Celsius gegebenenfalls aber auch bis auf 1.000° C aufgeheizt. Dies erfolgt im Wesentlichen durch Wärmestrahlung oder durch Wärmeleitung über das Gas in der Prozesskammer vom Suszeptor her. Durch die Gasleitungen 8 und/oder die Gasleitungen 9 kann HCl gegebenenfalls zusammen mit einem Trägergas, beispielsweise N₂ oder H₂ eingeleitet werden.

Da die Gaseinlassgehäusewand 10 und die Gasauslassplatte 14 beim Betrieb der Vorrichtung stark voneinander verschiedene Temperaturen aufweisen, und eine gleichmäßige Gasversorgung gewährleistet sein muss, müssen die Dimensionen der Ringspalte 17 und des Abstandsfreiraumes entsprechend gewählt werden. Neben der thermischen Ausdehnung der Gasauslassplatte 14 müssen auch Schwerkraftseinflüsse berücksichtigt werden, da die Gasauslassplatte 14 lediglich am Rand gehalten ist. Die Durchmesser der Öffnungen 16 sind jedenfalls so gewählt, dass bei einer thermischen Ausdehnung der Gasauslassplatte 14 keine Spannungen auf die Gaseinleitungsfortsätze 15 übertragen werden.

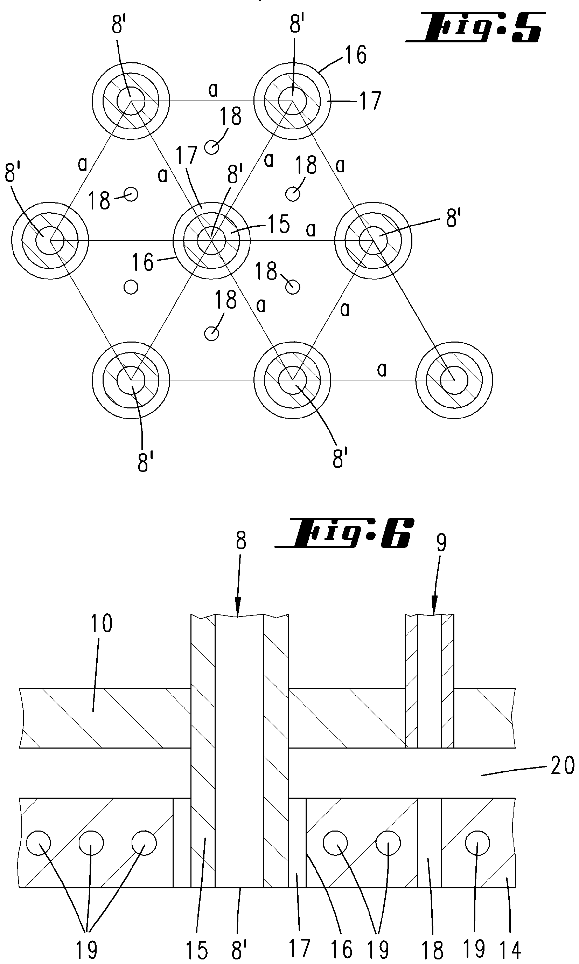

Bei dem in der Figur 6 dargestellten Ausführungsbeispiel besitzt die Gasauslassplatte 14 Temperierkanäle 19. Durch diese Temperierkanäle 19 kann eine heiße oder kalte Flüssigkeit strömen, so dass die Gasauslassplatte 14 nicht nur heißer als das Gaseinlassorgan 2 sein kann. Es ist vielmehr auch vorgesehen, dass Gaseinlassorgan 2 aufzuheizen und die Gasauslassplatte 14 zu kühlen, beispielsweise wenn auf einem auf dem Suszeptor 3 aufliegenden Substrat über Kondensation eine Schicht abgeschieden werden soll.

Die in den Zeichnungen 1 bis 4 lediglich in einem vereinfachten Querschnitt dargestellten Gasleitungen liegen in einer bevorzugten Ausgestaltung nicht in einer gemeinsamen Querschnittsebene.

Aus der Figur 5 ist ersichtlich, dass die ersten Gasleitungen 8 beziehungsweise deren Mündungen 8' auf den Eckpunkten eines gleichseitigen Dreiecks liegen. Jede Mündung 8' ist somit um den gleichen Abstand a von der ihm nächstliegenden Mündung 8' beabstandet. Es ergibt sich eine hexagonale Anordnung.

Die Öffnungen 18 der Gasauslassplatte 14, durch die das zweite Prozessgas in die Prozesskammer strömt, liegen ebenfalls in einer hexagonalen Zuordnung zueinander. Sie liegen etwa in den Mittelpunkten der gleichseitigen Dreiecke mit der Kantenlänge a.

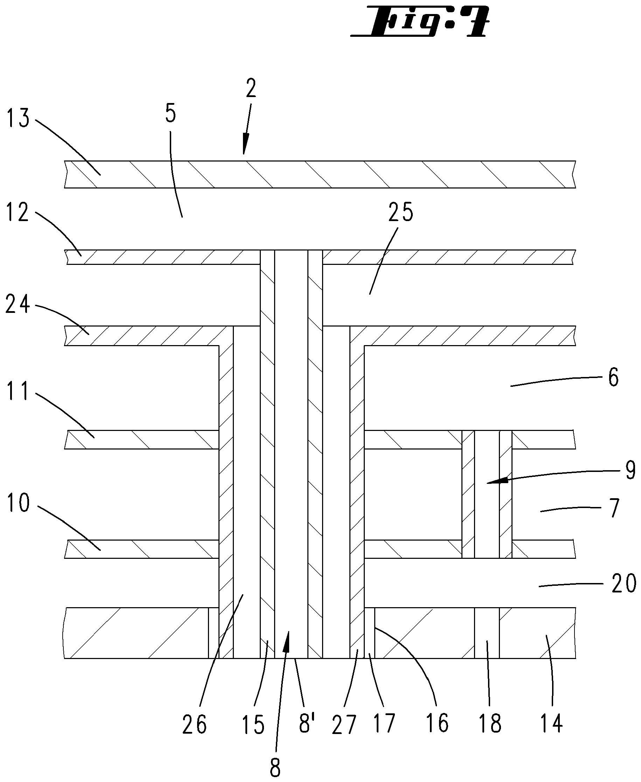

Während bei den in den Figuren 1 bis 4 beziehungsweise 6 dargestellten Ausführungsbeispiele das zweite Prozessgas auch durch die Ringspalte 17 in die Prozesskammer eintreten kann und somit unmittelbar vor der Mündung 8' mit dem ersten Prozessgas in Kontakt treten kann, ist bei dem in der Figur 7 dargestellten Ausführungsbeispiel ein zusätzlicher ringförmiger Strömungskanal 26 vorgesehen. Hierzu ist das die erste Gasleitung 8 ausbildende Röhrchen von einem durchmessergrößeren Röhrchen 27 umgeben. Durch den Spalt 26 zwischen den Röhrchen 8 und 27 kann ein Spülgas in die Prozesskammer 2 eingeleitet werden, welches in ein weiteres Gasverteilvolumen 25 eingespeist wird. Das Gasverteilvolumen 25 wird von einer Zwischenwand 24 vom Gasverteilvolumen 6 getrennt. Die Zwischenwand 12 trennt das Gasverteilvolumen 25 vom Gasverteilvolumen 5.

Zufolge des aus dem Ringspalt 17 austretenden Spülgases tritt das aus der Mündung 8' austretende erste Prozessgas erst in einem heißeren Bereich der Prozesskammer 2 mit dem durch den Spalt 17 austretenden zweiten Prozessgas in Kontakt. Hierdurch ist eine weitere Maßnahme gegeben, um eine Adduktbildung oder andere parasitäre Reaktionen in der Prozesskammer zu vermindern. Die Gasauslassplatte 14 kann einteilig oder mehrteilig sein. Die Gasauslassplatte 14 bildet darüber hinaus eine Temperaturabschirmung des gekühlten Gaseinlassorganes 2. Die Gasauslassplatte 14 kann sich durch die Wärmestrahlung, die vom Suszeptor 3 ausgeht, aufheizen. Es verbleiben lediglich kalte Inseln im Bereich der Mündungen 8'.

Das in der Figur 7 dargestellte Ausführungsbeispiel kann auch anderweitig betrieben werden, beispielsweise kann durch den Ringkanal 26 ein weiteres Prozessgas in die Prozesskammer eingeleitet werden. Durch die Gasleitungen 8 kann ein Spülgas oder ebenfalls ein Prozessgas in die Prozesskammer 22 eingeleitet werden.

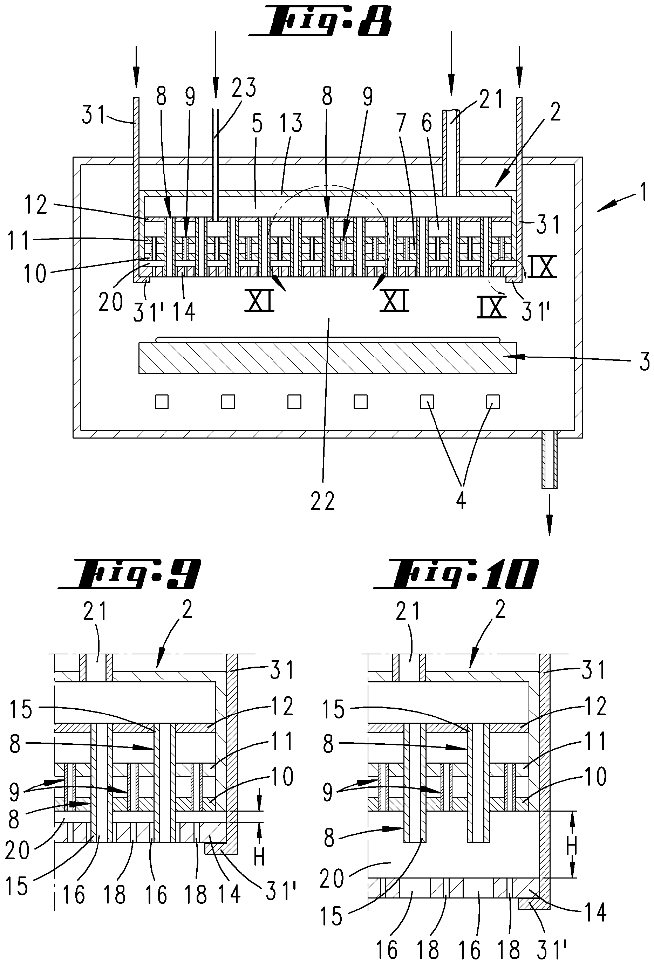

Je nach Höhe H des Abstandsfreiraum 20 und Leistung der Heizung 4 ist die Maximaltemperatur, auf die sich die untere Seite der Gasauslassplatte 14 aufheizen kann, nach oben begrenzt. In einem Wachstumsprozess liegt die Temperatur der Unterseite der Gasauslassplatte auf einer Temperatur die kleiner 450° C bzw. sogar kleiner 400° C ist. In einem Reinigungsschritt soll die Temperatur aber mindestens 500° C betragen. Um dies mit einfachen Mitteln erreichen zu können, ist bei den in den Figuren 8 bis 18 ausgeführten Ausführungsbeispiel eine Lagerveränderbarkeit der Gasauslassplatte 14 vorgesehen. Hierzu besitzt der Reaktor ein Verlagerungsmittel 31, mit dem die Gasauslassplatte 14 in Vertikalrichtung verlagerbar ist. Haken 31' untergreifen den Rand der Gasauslassplatte 14. Die Figur 8 zeigt die Gaseinlassplatte 14 in einer Produktionsprozessstellung, in der die Gasauslassplatte 14 auf eine Höhe gebracht ist, in der die Mündung 8' der ersten Gasleitung 8 mit der Unterseite der Gasauslassplatte 14 bündig verläuft. Die von den ersten Gasleitungen 8 gebildeten rohrförmigen Gasleitungsfortsätze 15 ragen hierbei unter Belassung eines Ringspaltes in die Öffnungen 16 der Gasauslassplatte 14 hinein.

Das Maß der Höhe H des Abstandsfreiraumes 20 kann vergrößert werden. Dies erfolgt durch Absenken der Gasauslassplatte 14 mit Hilfe der Hubelemente 31 vergrößert werden. Hierbei entfernt sich die Gasauslassplatte 14 von der gekühlten Gaseinlassgehäusewand 10 und nähert sich der beheizten Oberseite des Suszeptors 3 an. Wie der Figur 10 zu entnehmen ist, ragen dann die Gaseinleitungsfortsätze 15 nicht mehr in die Öffnungen 16 hinein. In dieser Betriebsstellung kann sich die Gasauslassplatte 14 im Reinigungsprozess auf über 500° C aufheizen. Im Ausführungsbeispiel sind Hubelemente 31 vorgesehen, um die Gasauslassplatte 14 zwischen dem ortsfest gehaltenen Gaseinlassorgan 2 und dem dazu ortsfest gehaltenen Suszeptor 3 zu verlagern. Es sind aber auch alternative Ausgestaltungen möglich, beispielsweise kann der Abstand H auch durch ein Anheben des Gaseinlassorgans 2 vergrößert werden. Denkbar ist auch, dass aus Gaseinlassorgan 2 und Gasauslassplatte 4 bestehende Ensemble insgesamt in Richtung auf den Suszeptor 3 abzusenken bzw. den Suszeptor 3 in Richtung auf das Ensemble anzuheben. Wesentlich ist jeweils, dass sich das Verhältnis der Abstände zwischen Gasauslassplatte 14 und Gaseinlassorgan 2 einerseits bzw. Gasauslassplatte 14 und Suszeptor 3 andererseits verändert.

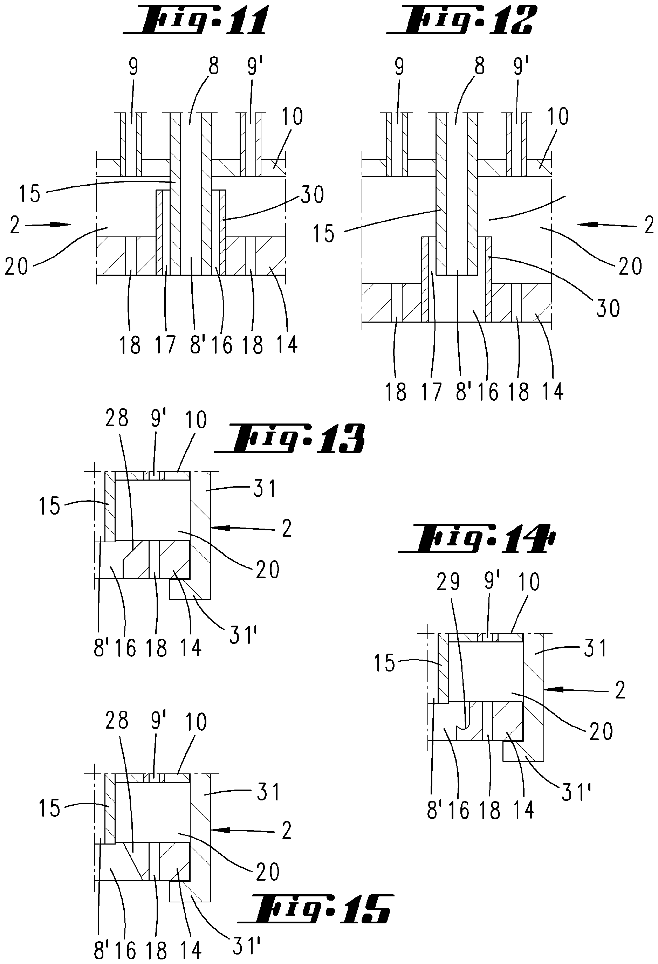

Bei dem in den Figuren 11 und 12 dargestellten fünften Ausführungsbeispiel werden die Öffnungen 16 von Hülsen 30 ausgebildet, die in entsprechenden Öffnungen der Gasauslassplatte 14 stecken. Die Hülsen 30 schließen dabei mit der zur Prozesskammer weisenden Oberfläche der Gasauslassplatte 14 bündig ab, ragen aber in den Abstandsfreiraum 20 hinein. Bei dieser Konstellation lässt sich die Gasauslassplatte 14 absenken, ohne dass die Mündung 8' der ersten Gasleitung 8 aus der Öffnung 16 heraustritt. Auch in der abgesenkten Stellung der Gasauslassplatte 14 bleibt der Ringspalt 17 zwischen der Außenwandung des Gaseinleitungsfortsatzes 15 und der Innenwandung der Öffnung 16 also der Innenwandung der Hülse 30 erhalten. Die Hülse 30 kann aus einem geeigneten Material, beispielsweise aus einem Metall, aus Graphit, aus beschichtetem Graphit oder aus Quarz bestehen. Sie ist in eine Öffnung der Gasauslassplatte 14 eingesteckt. Sie kann dort auch formschlüssig gehalten sein.

Das in der Figur 13 dargestellte sechste Ausführungsbeispiel zeigt eine Profilierung der Wandung der Öffnung 16. Die Profilierung 28 wird dort von einer Fase ausgebildet, die auf der zur Gaseinlassgehäusewand 10 weisenden Seite der Gasauslassplatte 14 vorgesehen ist.

Das in der Figur 14 dargestellte siebte Ausführungsbeispiel zeigt eine anders gestaltete Profilierung 29 der Wandung der Öffnung 16. Die Profilierung 29 wird hier von einer Stufe gebildet, wobei die Stufe eine Kehle ausbildet, die sich zur von der Prozesskammer wegweisenden Seite öffnet.

Bei dem in der Figur 15 dargestellten achten Ausführungsbeispiel besitzt die Öffnung 16 eine Wandungsprofilierung 28, die als Fase ausgebildet ist. Die gesamte Öffnungswandung verläuft auf einer Kegelstumpfinnenfläche, wobei sich der kegelstumpfförmige Raum zur Prozesskammer hin öffnet.

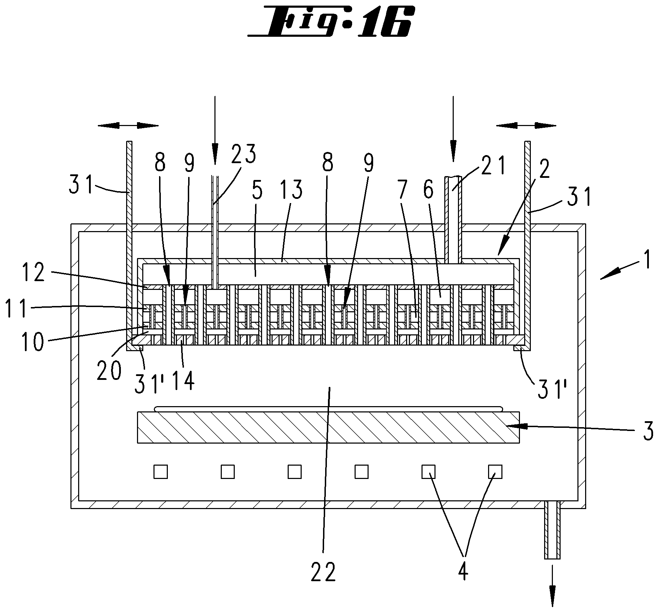

Das in der Figur 16 dargestellte neunte Ausführungsbeispiel zeigt eine Gasauslassplatte 14, die in Horizontalrichtung verlagerbar ist. Durch eine Horizontalverlagerung können die Öffnungen 16 in einen wärmeleitenden Kontakt zu den gekühlten Gasleitungsfortsätzen 15 gebracht werden.

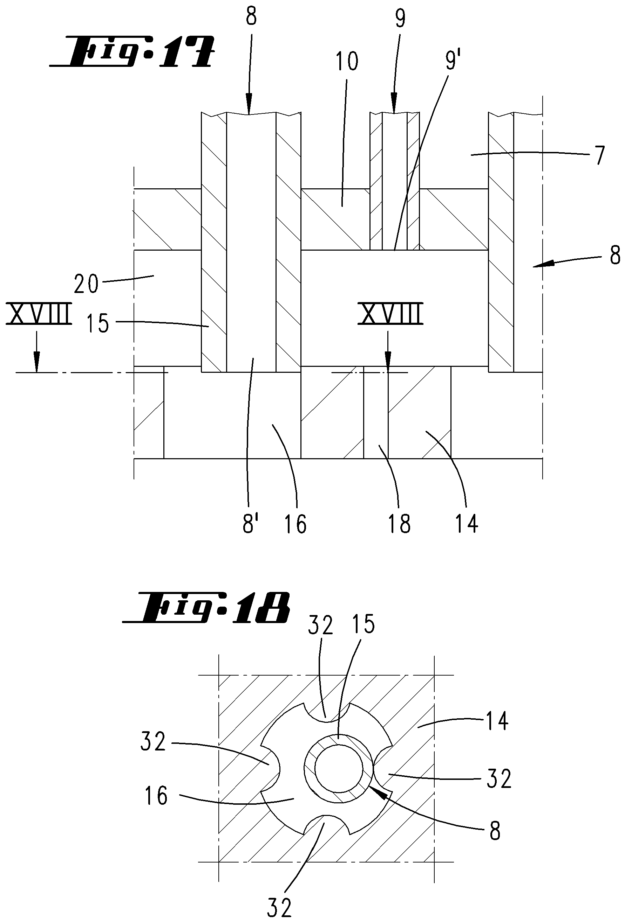

Die Figur 17 zeigt eine vergrößerte Darstellung, bei der durch Horizontalverlagerung der Gasauslassplatte 14 der thermische Kontakt hergestellt ist. Hier ist die Gasauslassplatte 14 zusätzlich noch in Vertikalrichtung abgesenkt worden. Die Figur 18 zeigt eine besonders gestaltete Querschnittskontur einer Öffnung 16. Von einer kreisrunden Grundlinie ragen in gleichmäßiger Winkel verteilung vier halbkreisförmige Vorsprünge 32 in den Öffnungsfreiraum 16 hinein. Durch die Vertikalverlagerung kann einer der Vorsprünge 32 in wärmeleitenden Kontakt zum Gasleitungsfortsatz 15 gebracht werden.

**Bezugszeichenliste**

| | | | |
|---|---|---|---|
| 1 | Reaktorgehäuse | 25 | Gasverteilvolumen |
| 2 | Gaseinlassorgan | 26 | Spülgasleitung |
| 3 | Suszeptor | 27 | Rohr |
| 4 | Heizung | 28 | Profilierung |
| 5 | erstes Gasverteilvolumen | 29 | Profilierung |
| 6 | zweites Gasverteilvolumen | 30 | Hülse |
| 7 | Kühlmittelkammer | 31 | Verlagerungsmittel |
| 8 | erste Gasleitung | 31' | Haken |
| 8' | Mündung | 32 | Vorsprung |
| 9 | zweite Gasleitung | a | Kantenlänge |
| 9' | Mündung | H | Höhe |
| 10 | Gaseinlassgehäusewand | | |
| 11 | Zwischenwand | | |
| 12 | Zwischenwand | | |
| 13 | Gaseinlassgehäusewand | | |
| 14 | Gasauslassplatte | | |
| 15 | Gasleitungsfortsatz | | |
| 16 | Öffnung | | |
| 17 | Ringspalt | | |
| 18 | Öffnung | | |
| 19 | Temperierkanal | | |
| 20 | Abstandsfreiraum | | |
| 21 | Zuleitung | | |
| 22 | Prozesskammer | | |
| 23 | Zuleitung | | |
| 24 | Zwischenwand | | |

## Patentansprüche

1. Gaseinlassorgan (2) eines CVD-Reaktors mit einem Gaseinlassgehäuse, welches zumindest ein erstes, von einer ersten Zuleitung (21) mit einem ersten Prozessgas speisbares Gasverteilvolumen (5) aufweist, welches eine Vielzahl von jeweils als Rohr ausgebildete erste Gasleitungen (8) aufweist, die in erste Öffnungen (16) einer vor einer Gaseinlassgehäusewand (10) angeordneten Gasauslassplatte (14) eingreifen und durch die das erste Prozessgas in eine unter der Gasauslassplatte (14) angeordneten Prozesskammer eintritt, mit einem zwischen der Gaseinlassgehäusewand (10) und der Gasauslassplatte (14) angeordneten Abstandsfreiraum (20), mit einer an die Gaseinlassgehäusewand (10) angrenzenden Kühlmittelkammer (7), in die ein Kühlmittel einspeisbar ist, um die Gaseinlassgehäusewand (10) und die Mündungen (8') der in Wärmeleitverbindung zur gekühlten Gaseinlassgehäusewand (10) stehenden Gasleitungen (8) zu kühlen, wobei die erste Gasleitung (8) die Kühlmittelkammer (7) kreuzt, wobei die Gasauslassplatte (14) gegenüber der Gaseinlassgehäusewand (10) thermisch entkoppelt ist, und sich von der Prozesskammer (22) her durch Strahlungswärme aufheizt, und mit einem zweiten von einer zweiten Zuleitung (23) mit einem zweiten Prozessgas speisbaren Gasverteilvolumen (6), wobei die Gasauslassplatte (14) Öffnungen (17, 18) aufweist, durch die das zweite Prozessgas in die Prozesskammer (22) austreten kann, **dadurch gekennzeichnet, dass** das zweite Gasvolumen (6) mit einer Vielzahl von zweiten Gasleitungen (9) mit der Gaseinlassgehäusewand (10) verbunden ist, die durch die Kühlmittelkammer (7) hindurchtreten und in den Abstandsfreiraum (20) münden.

2. Gaseinlassorgan (2) nach Anspruch 1, **dadurch gekennzeichnet, dass** die Mündungen (8') der Gasleitungen (8) im Wesentlichen bündig in der zur Prozesskammer (22) weisenden Oberfläche der Gasauslassplatte (14) liegen oder durch eine Vertikalverlagerung der Gasauslassplatte (14) bündig zu dieser Oberfläche bringbar sind.

3. Gaseinlassorgan (2) nach einem der vorherigen Ansprüche, **dadurch gekennzeichnet, dass** Gasleitungsfortsätze (15), mit denen die ersten Gasleitungen (18) in die ihnen zugeordneten ersten Öffnungen (16) hineinragen, einen Außendurchmesser aufweisen, der geringer ist, als die Öffnungsweite der ersten Öffnungen (16), so dass die Gasleitungsfortsätze (15) jeweils von einem Ringspalt (17) umgeben sind.

4. Gaseinlassorgan (2) nach einem der vorherigen Ansprüche, **dadurch gekennzeichnet, dass** die Mündungen (8') der ersten Gasleitungen (8) in der Gasauslassplatte (14) auf Eckpunkten gleichseitiger Dreiecke liegen.

5. Gaseinlassorgan (2) nach einem der Ansprüche 1 bis 4, **dadurch gekennzeichnet, dass** die zweiten Öffnungen (18) auf den Mittelpunkten der gleichseitigen Dreiecke liegen.

6. Gaseinlassorgan (2) nach einem der vorherigen Ansprüche, **dadurch gekennzeichnet, dass** die erste Gaszuleitung von einer dritten, insbesondere Spülgas- oder Prozessgasleitung (26) umgeben ist, die von einem dritten Plenum (25) gespeist wird.

7. Gaseinlassorgan (2) nach einem der vorherigen Ansprüche, **dadurch gekennzeichnet, dass** die Gasauslassplatte (14) temperierbar ist und insbesondere Temperierkanäle (19) aufweist

8. Gaseinlassorgan (2) nach einem der vorherigen Ansprüche, **dadurch gekennzeichnet, dass** der Abstand (H) zwischen Gaseinlassgehäusewand (10) und Gasauslassplatte (14) bzw. der Abstand der Gasauslassplatte (14) zum Suszeptor (3) insbesondere mit Hilfe einer Verlagerungseinrichtung (31) variierbar ist.

9. Gaseinlassorgan (2) nach einem der vorherigen Ansprüche, **dadurch gekennzeichnet, dass** die Gasauslassplatte (14) in ihrer Erstreckungsebene derart verlagerbar ist, dass sie in eine Wärmeleitverbindung zu den Gasleitungsfortsätzen (15) bringbar ist.

10. Gaseinlassorgan (2) nach einem der Ansprüche 1 bis 9, **gekennzeichnet durch** eine die Gasströmung durch die Öffnung (16) beeinflussende Profilierung (28, 29) der Öffnungen (16).

11. Gaseinlassorgan (2) nach einem der vorherigen Ansprüche, **dadurch gekennzeichnet, dass** die Öffnung (16) die Höhlung einer Hülse (30) ist, die sich in den Abstandsfreiraum (20) erstreckt.

12. Gaseinlassorgan (2) nach einem der vorherigen Ansprüche, **dadurch gekennzeichnet, dass** die thermische Leitfähigkeit der Gasauslassplatte (14) geringer ist, als die thermische Leitfähigkeit der Gasleitungen (8).

## Claims

1. Gas inlet member (2) of a CVD reactor, comprising a gas inlet housing having at least one first gas distribution volume (5) to which a first process gas can be fed by a first supply line (21) and which has a plurality of first gas lines (8), which gas lines are each designed as a pipe and engage in first openings (16) of a gas outlet plate (14) arranged in front of a gas inlet housing wall (10), and through which gas lines the first process gas enters a process chamber arranged under the gas outlet plate (14),
the gas inlet member also comprising a clearance space (20) arranged between the gas inlet housing wall (10) and the gas outlet plate (14), and comprising a coolant chamber (7) which is adjacent to the gas inlet housing wall (10) and into which a coolant can be fed in order to cool the gas inlet housing wall (10) and the mouths (8') of the gas lines (8) that are thermally conductively connected to the cooled gas inlet housing wall (10),
the first gas line (8) crossing the coolant chamber (7), the gas outlet plate (14) being thermally decoupled from the gas inlet housing wall (10) and being heated from the process chamber (22) by radiant heat, and the gas inlet member further comprising a second gas distribution volume (6) to which a second process gas can be fed by a second supply line (23), the gas outlet plate (14) having openings (17, 18) through which the second process gas can escape into the process chamber (22),
**characterised in that** the second gas volume (6) is connected to the gas inlet housing wall (10) via a plurality of second gas lines (9) that pass through the coolant chamber (7) and open into the clearance space (20).

2. Gas inlet member (2) according to claim 1, **characterised in that** the mouths (8') of the gas lines (8) lie substantially flush in the surface of the gas outlet plate (14), which surface faces the process chamber (22), or can be can be brought flush with said surface by means of a vertical movement of the gas outlet plate (14).

3. Gas inlet member (2) according to either of the preceding claims, **characterised in that** gas line extensions (15) by means of which the first gas lines (18) protrude into the first openings (16) associated therewith have an outer diameter which is smaller than the opening width of the first openings (16), such that the gas line extensions (15) are each surrounded by an annular gap (17).

4. Gas inlet member (2) according to any of the preceding claims, **characterised in that** the mouths (8') of the first gas lines (8) are positioned in the gas outlet plate (14) on vertices of equilateral triangles.

5. Gas inlet member (2) according to any of claims 1 to 4, **characterised in that** the second openings (18) are positioned on the midpoints of the equilateral triangles.

6. Gas inlet member (2) according to any of the preceding claims, **characterised in that** the first gas supply line is surrounded by a third gas line, in particular a flushing gas line or process gas line (26), which is fed by a third plenum (25).

7. Gas inlet member (2) according to any of the preceding claims, **characterised in that** the gas outlet plate (14) can be temperature-controlled and in particular has temperature-control channels (19).

8. Gas inlet member (2) according to any of the preceding claims, **characterised in that** the distance (H) between the gas inlet housing wall (10) and gas outlet plate (14) or the distance between the gas outlet plate (14) and the susceptor (3) can be varied, in particular with the aid of a movement device (31).

9. Gas inlet member (2) according to any of the preceding claims, **characterised in that** the gas outlet plate (14) can be moved in its plane of extension in such a way that it can be brought into thermally conductive connection with the gas line extensions (15).

10. Gas inlet member (2) according to any of claims 1 to 9, **characterised by** a shape (28, 29) of the openings (16) that influences the gas flow through the opening (16).

11. Gas inlet member (2) according to any of the preceding claims, **characterised in that** the opening (16) is the cavity of a sleeve (30) which extends into the clearance space (20).

12. Gas inlet member (2) according to any of the preceding claims, **characterised in that** the thermal conductivity of the gas outlet plate (14) is lower than the thermal conductivity of the gas lines (8).

## Revendications

1. Élément d'entrée de gaz (2) d'un réacteur CVD, ledit élément comprenant un boîtier d'entrée de gaz qui comporte au moins un premier volume de distribution de gaz (5) pouvant être alimenté avec un premier gaz de traitement par une première conduite d'alimentation (21) et comportant une pluralité de premières conduites de gaz (8) qui sont conçues chacune comme un tube, qui s'engagent dans des premières ouvertures (16) d'une plaque de sortie de gaz (14) disposée devant une paroi de boîtier d'entrée de gaz (10) et par lesquelles le premier gaz de traitement entre dans une chambre de traitement disposée au-dessous de la plaque de sortie de gaz (14), un espace de dégagement (20) ménagé entre la paroi de boîtier d'entrée de gaz (10) et la plaque de sortie de gaz (14), une chambre d'agent de refroidissement (7) qui est adjacente à la paroi de boîtier d'entrée de gaz (10) et dans laquelle un agent de refroidissement peut être introduit pour refroidir la paroi de boîtier d'entrée de gaz (10) et les embouchures (8') des conduites de gaz (8) qui sont reliées de manière thermoconductrice à la paroi de boîtier d'entrée de gaz (10) refroidie, la première conduite de gaz (8) croisant la chambre de d'agent de refroidissement (7), la plaque de sortie de gaz (14) étant découplée thermiquement de la paroi de boîtier d'entrée de gaz (10) et étant chauffée par la chaleur rayonnante provenant de la chambre de traitement (22), et un deuxième volume de distribution de gaz (6) qui peut être alimenté avec un deuxième gaz de traitement par une deuxième conduite d'alimentation (23), la plaque de sortie de gaz (14) comportant des ouvertures (17, 18) par lesquelles le deuxième gaz de traitement peut sortir dans la chambre de traitement (22), **caractérisé en ce que** le deuxième volume de gaz (6) étant relié à la paroi de boîtier d'entrée de gaz (10) par une pluralité de deuxièmes conduites de gaz (9) qui traversent la chambre d'agent de refroidissement (7) et débouchent dans l'espace de dégagement (20).

2. Élément d'entrée de gaz (2) selon la revendication 1, **caractérisé en ce que** les embouchures (8') des conduites de gaz (8) sont sensiblement à fleur de la surface de la plaque de sortie de gaz (14) qui est dirigée vers la chambre de traitement (22) ou peuvent être amenées à fleur de ladite surface par un déplacement vertical de la plaque de sortie de gaz (14).

3. Élément d'entrée de gaz (2) selon l'une des revendications précédentes, **caractérisé en ce que** des prolongements de conduite de gaz (15), avec lesquels les premières conduites de gaz (18) font saillie dans les premières ouvertures (16) qui leur sont associées, ont un diamètre extérieur qui est inférieur à la largeur des premières ouvertures (16) de sorte que les prolongements de conduite de gaz (15) sont entourés chacun par un espace annulaire (17).

4. Élément d'entrée de gaz (2) selon l'une des revendications précédentes, **caractérisé en ce que** les embouchures (8') des premières conduites de gaz (8) de la plaque de sortie de gaz (14) sont situées aux sommets de triangles équilatéraux.

5. Élément d'entrée de gaz (2) selon l'une des revendications 1 à 4, **caractérisé en ce que** les deuxièmes ouvertures (18) sont situées au centre des triangles équilatéraux.

6. Élément d'entrée de gaz (2) selon l'une des revendications précédentes, **caractérisé en ce que** la première conduites d'alimentation en gaz est entourée par une troisième conduite(26), notamment de gaz de rinçage ou de gaz de traitement, qui est alimentée par un troisième plénum (25) .

7. Élément d'entrée de gaz (2) selon l'une des revendications précédentes, **caractérisé en ce que** la plaque de sortie de gaz (14) peut être régulée en température et comporte notamment des canaux de régulation en température (19) .

8. Élément d'entrée de gaz (2) selon l'une des revendications précédentes, **caractérisé en ce que** la distance (H) entre la paroi de boîtier d'entrée de gaz (10) et la plaque de sortie de gaz (14) ou la distance de la plaque de sortie de gaz (14) au suscepteur (3) est variable, notamment à l'aide d'un dispositif de déplacement (31).

9. Élément d'entrée de gaz (2) selon l'une des revendications précédentes, **caractérisé en ce que** la plaque de sortie de gaz (14) peut être déplacée dans son plan d'extension afin de pouvoir être reliée de manière thermoconductrice aux prolongements de conduite de gaz (15).

10. Élément d'entrée de gaz (2) selon l'une des revendications 1 à 9, **caractérisé par** un profilage (28, 29) des ouvertures (16) qui influe sur l'écoulement de gaz à travers l'ouverture (16).

11. Élément d'entrée de gaz (2) selon l'une des revendications précédentes, **caractérisé en ce que** l'ouverture (16) est la cavité d'un manchon (30) qui s'étend jusque dans l'espace de dégagement (20).

12. Élément d'entrée de gaz (2) selon l'une des revendications précédentes, **caractérisé en ce que** la conductivité thermique de la plaque de sortie de gaz (14) est inférieure à la conductivité thermique des conduites de gaz (8) .
